# EUROPEAN PATENT APPLICATION

(11) **EP 2 639 837 A1**
(43) Date of publication of application: **18.09.2013**
(21) Application number: 11844405.8
(22) Date of filing: 11.11.2011
(51) Int. Cl.: H01L 31/042

(54) **THIN-FILM SOLAR CELL MODULE AND METHOD FOR MANUFACTURING THIN-FILM SOLAR CELL MODULE**

(30) Priority: 01.12.2010 JP 2010268738
(71) Applicant: Dexerials Corporation, Tokyo 141-0032 (JP)
(72) Inventor: MORI, Daichi, Tochigi 322 8503 (JP)
(74) Representative: Hill, Christopher Michael
(86) International application number: PCT/JP2011/076041
(87) International publication number: WO 2012/073675

(57) **Abstract**

A thin-film solar cell module, including: a thin-film solar cell including an electrode; a tab line; and an adhesive layer, wherein the tab line includes convex portions only on one surface thereof, wherein the adhesive layer is disposed only on the one surface of the tab line including the convex portions, and wherein the electrode and the one surface of the tab line including the convex portions are adhered and electrically connected via the adhesive layer.

## Description

### Technical Field

The present invention relates to a thin-film solar cell module and a method for manufacturing a thin-film solar cell module.

### Background Art

A solar cell is expected as a new source of energy since it converts sunlight which is clean and supplied inexhaustible directly into electricity.

The solar cell is used as a solar cell module in which a plurality of solar cells is connected via a tab line.

As a conventional tab line, a copper wire with a solder coated on a surface thereof has been used. However, a high temperature required for a solder connection causes sources of defects such as panel cracking and warping of a light-receiving surface and short circuit due to a solder protruded (leaked) from a tab line.

Thus, as a connecting material which is to replace a solder, an adhesive such as electrically conductive adhesive has been used. As a tab line with such an adhesive coated thereon, a tab line that the whole surface of a copper line is coated with an electrically conductive adhesive is exemplified. It is possible to reduce occurrences of problems such as warping or cracking of a solar cell since such a tab line may be connected at a low temperature.

As the solar cell module, there exist mainly "crystalline solar cell module" and "thin-film solar cell module".

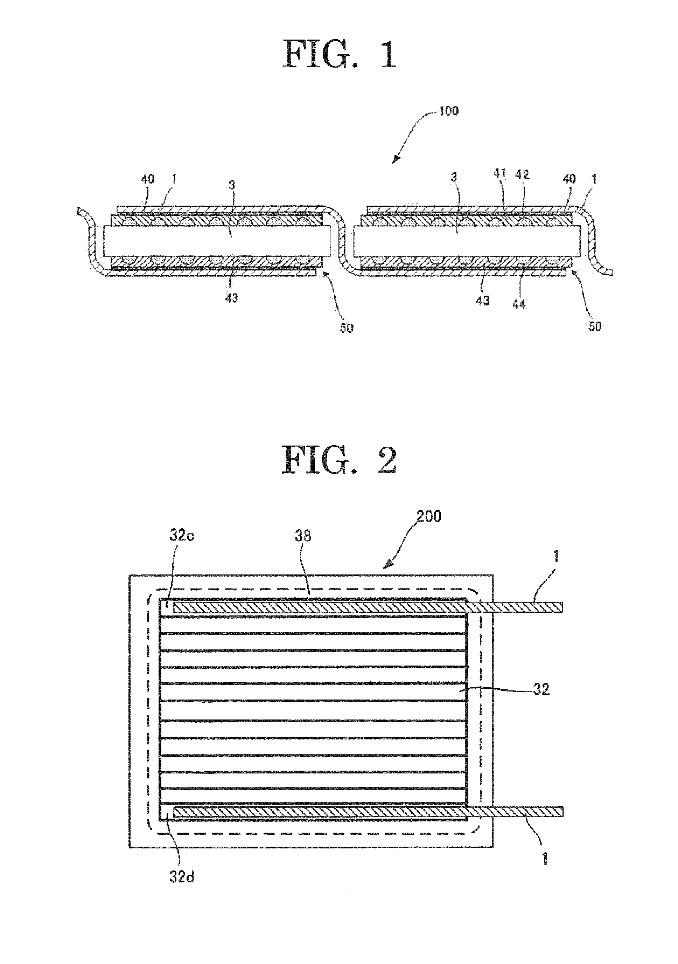

A structure of the crystalline solar cell module which employs an adhesive as a connecting material is explained. FIG. 1 is a schematic partial cross-sectional diagram illustrating one example of a crystalline solar cell module 100. In the crystalline solar cell module 100 of FIG. 1, a plurality of crystalline solar cells 50 are connected in series by a tab line 1 which acts as an interconnector. Here, the crystalline solar cells 50 are respectively composed of: a photoelectric conversion element 3; a first electrode 41 which is a bus-bar electrode as a surface electrode disposed on a light-receiving surface of the photoelectric conversion element 3; a second electrode 43 which is a bus-bar electrode disposed on a non-light-receiving surface; and finger electrodes 42, 44 as collector electrodes provided substantially perpendicular to the first electrode 41 ad the second electrode 43 on the photoelectric conversion element 3. A conductive adhesive layer 40 is formed at a predetermined location on the both surfaces of the tab line 1, and the tab line 1 electrically connects the first electrode 41 of one crystalline solar cell 50 and the second electrode 43 of the other crystalline solar cell 50 of adjacent crystalline solar cells 50 using the both surfaces of the tab line 1.

Next, a structure of the thin-film solar cell module using an adhesive as a connecting material is explained. FIG. 2 is a schematic top view illustrating one example of a thin-film solar cell module 200. The thin-film solar cell module 200 of FIG. 2 has a structure that a thin-film solar cell 32 is composed of thin-film photoelectric conversion elements connected in series on a substrate 38 in a planar direction and that a tab line 1 for electric power extraction is connected to a surface electrode (not shown) of a thin-film solar cell 32c at one end and a surface electrode (not shown) of a thin-film solar cell 32d at the other end via a conductive adhesive layer (not shown).

As described above, since the crystalline solar cell module and the thin-film solar cell module have different structures, unlike the tab line used for the crystalline solar cell module, the tab line used for the thin-film solar cell module usually includes a conductive adhesive layer on one surface of the tab line, and only the one surface is used for an electrical connection.

The thin-film solar cell module is advantageous compared to the crystalline solar cell module since it is easier to increase its area and it may be manufactured at a low cost, and thus aggressive development has been underway.

As a solar cell module using an adhesive as a connecting material as described above, a solar cell module which uses a tab line equipped with a metal foil and an adhesive layer disposed on at least one surface of the metal foil and composed of an adhesive including electrically conductive particles is proposed (see PTL1).

Also, a solar cell module which uses a tab line composed of a metal layer, a pair of conductive adhesive layers disposed at a predetermined interval on one surface of the metal layer, and an insulating adhesive layer sandwiched by the both conductive adhesive layers is proposed (see PTL2).

However, these proposed technologies relate to a crystalline solar cell module, and they cannot be applied directly to a thin-film solar cell module. Also, they have a problem of inferior connection reliability.

Thus, as a technology relating to improvement of connection reliability, a crystalline solar cell module which uses a tab line including convex portions on both surfaces thereof which contacts a connecting electrode of the solar cell is proposed (see PTL3).

However, this proposed technology relates to a crystalline solar cell module, and it cannot be applied directly to a thin-film solar cell module.

Also, a solar cell module is usually sealed by a sealant for usage, but an electrically connecting an electrode and a tab line and sealing by a sealant are carried out in different steps. Thus, there is a problem of complicated steps.

Accordingly, regarding a thin-film solar cell module which uses an adhesive as a connecting material, there currently is being asked to provide a thin-film solar cell module having superior connection reliability and a method for producing a thin-film solar cell module which can produce the thin-film solar cell module in fewer steps.

### Citation List

### Patent Literature

PTL1: International Publication No. WO/2007/125903
PTL2: Japanese Patent Application Laid-Open (JP-A) No. 06-196743
PTL3: JP-A No. 2008-147567

### Summary of Invention

### Technical Problem

The present invention aims at solving the above problems in the conventional technologies and at achieving the following objective. That is, the present invention aims at providing a thin-film solar cell module using an adhesive as a connecting material and having superior connection reliability and a method for manufacturing a thin-film solar cell module which is capable of manufacturing the thin-film solar cell module with a fewer steps.

### Solution to Problem

Means for solving the problems are as follows. That is,
<1> A thin-film solar cell module, including:
   a thin-film solar cell including an electrode;
   a tab line; and
   an adhesive layer,
   wherein the tab line includes convex portions only on one surface thereof,
   wherein the adhesive layer is disposed only on the one surface of the tab line including the convex portions, and
   wherein the electrode and the one surface of the tab line including the convex portions are adhered and are electrically connected via the adhesive layer.
<2> The thin-film solar cell module according to <1>,
   wherein a ratio (Rz/A) of a ten-point average roughness (Rz (µm)) of the convex portions included in the tab line to an average thickness (A (µm)) of the adhesive layer is 0.5 to 2.0.
<3> A method for manufacturing a thin-film solar cell module,
   wherein the thin-film solar cell module is the thin-film solar cell module according to <1> or <2>,
   wherein the method uses a decompression laminator,
   wherein the decompression laminator includes a first chamber, a second chamber, a flexible sheet, and a heating stage which is heatable,
   wherein the first chamber and the second chamber are partitioned by the flexible sheet,
   wherein an internal pressure of each of the first chamber and the second chamber is independently adjustable, and
   wherein the heating stage is disposed in the second chamber,
   wherein the method includes:
   disposing, wherein the thin-film solar cell with the electrode formed thereon is disposed on the heating stage in the second chamber, the adhesive layer and the tab line with the convex portions only on one surface thereof are disposed on the electrode so that the electrode and the one surface of the tab line are adhered and electrically connected via the adhesive layer by pressing and heating, and further a sealing resin and either a moisture-proof back sheet or a glass plate are disposed so as to cover the thin-film solar cell;
   pressing, wherein the internal pressure of the first chamber is increased relative to the second chamber so as to press either the moisture-proof back sheet or the glass plate by the flexible sheet; and
   heating, wherein the heating stage is heated.
<4> The method for manufacturing a thin-film solar cell module according to <3>,
   wherein the increasing the internal pressure of the first chamber relative to the second chamber is to reduce the internal pressures of the first chamber and the second chamber to a reduced-pressure condition and then to vent the first chamber while maintaining the reduced-pressure condition of the second chamber.
<5> The method for manufacturing a thin-film solar cell module according to <3> or <4>,
   wherein the tab line and the adhesive layer are laminated before disposed on the electrode.

### Advantageous Effects of Invention

The present invention may solve the conventional problems and achieve the objectives above, and regarding a thin-film solar cell module using an adhesive as a connecting material, it is possible to provide a thin-film solar cell module having superior connection reliability and a method for manufacturing a thin-film solar cell module which can produce the thin-film solar cell module with a fewer steps.

### Brief Description of Drawings

FIG. 1 is a schematic partial cross-sectional diagram illustrating one example of a crystalline solar cell module.
FIG. 2 is a schematic top view illustrating one example of a thin-film solar cell module.
FIG. 3 is a schematic cross-sectional diagram illustrating a tab line including convex portions on which an adhesive layer is laminated.
FIG. 4 is a schematic cross-sectional diagram illustrating one example of a thin-film solar cell module of the present invention.
FIG. 5 is a schematic cross-sectional diagram of one example of a decompression laminator before use.
FIG. 6A is a diagram for explaining the use of a decompression laminator.
FIG. 6B is a diagram for explaining the use of a decompression laminator.
FIG. 6C is a diagram for explaining the use of a decompression laminator.
FIG. 6D is a diagram for explaining the use of a decompression laminator.
FIG. 6E is a diagram for explaining the use of a decompression laminator.
FIG. 7A is a schematic cross-sectional diagram for explaining a disposing step.
FIG. 7B is a schematic cross-sectional diagram for explaining a pressing step and a heating step.
FIG. 7C is a schematic cross-sectional diagram illustrating one example of a thin-film solar cell module of the present invention.

### Description of Embodiments

### (Thin-Film Solar Cell Module)

A thin-film solar cell module of the present invention includes a thin-film solar cell, a tab line and an adhesive layer, and it further includes other members such as sealing resin, moisture-proof back sheet and glass plate according to necessity.

### <Thin-film solar cell>

The thin-film solar cell is not particularly restricted as long as it includes a photoelectric conversion element as a photoelectric conversion unit and an electrode, and it may be appropriately selected according to purpose. Examples thereof include amorphous silicon solar cells, CdS/CdTe solar cell, dye-sensitized solar cells, organic thin-film solar cells and microcrystalline silicon solar cells (tandem solar cells).

An average thickness of the thin-film solar cell is not particularly restricted, and it may be appropriately selected according to purpose.

### -Electrode-

The electrode is not particularly restricted, and it may be appropriately selected according to purpose. Examples thereof include an external electrode in a region of an elongated current extraction unit.

### <Tab line>

The tab line is not particularly restricted as long as it includes convex portions only on one surface thereof, and it may be appropriately selected according to purpose.

The convex portions denote convex portions having a ten-point average roughness (Rz (µm)) of 1.0 µm or greater.

A size of the convex portions is not particularly restricted as long as the ten-point average roughness (Rz (µm)) is 1.0 µm or greater, and it may be appropriately selected according to purpose. Nonetheless, it is preferably 2.5 µm to 25 µm, more preferably 5 µm to 20 µm, and particularly preferably 7 µm to 15 µm. When the Rz is less than 1.0 µm, there are cases where a problem occurs in the electrical connection. When it exceeds 25 µm, there are cases where a problem occurs in the electrical connection. The Rz in the particularly preferable range is advantageous in view of connection reliability.

Here, the ten-point average roughness (Rz) may be measured in accordance with JIS B 0601-2001 (compliant with ISO 4287-1997).

A material and a structure of the convex portions are not particularly restricted, and they may be appropriately selected according to purpose. Examples thereof include copper particles with a surface thereof plated with zinc.

A method for forming the convex portions is not particularly restricted, and it may be appropriately selected according to purpose. Examples thereof include a method of disposing copper particles on one surface of a smooth tab line and plating this tab line with zinc to form convex portions.

Also, for example, copper particles are disposed on one surface of a smooth copper foil, and the copper foil is plated with zinc. Then, the copper foil is slit to a predetermined width. Thereby, the tab line including the convex portions may be prepared.

The convex portions may be formed entirely or partially on the one surface of the tab line.

Examples of a material of the tab line include copper, aluminum, iron, gold, silver, nickel, palladium, chrome, molybdenum and alloys thereof. Also, these metals may be plated with gold, silver, tin and solder according to necessity.

Examples of a shape of the tab line include a ribbon.

An average width of the tab line is not particularly restricted, and it may be appropriately selected according to purpose. Nonetheless, it is preferably 1 mm to 6 mm.

An average thickness of the tab line is not particularly restricted, and it may be appropriately selected according to purpose. Nonetheless, it is preferably 5 µm to 300 µm.

### <Adhesive layer>

The adhesive layer is disposed only on one surface of the tab line including the convex portions.

A method for forming the adhesive layer is not particularly restricted, and it may be appropriately selected according to purpose. Examples thereof include: a method of laminating a film-shaped adhesive (adhesive film) on the tab line; and a method of coating a liquid adhesive on the tab line.

A method of coating the adhesive is not particularly restricted, and it may be appropriately selected according to purpose. Examples thereof include a spin-coating method, a casting method, a micro-gravure coating method, a gravure coating method, a knife coating method, a bar coating method, a roll coating method, a wire-bar coating method, a dip coating method and a spray coating method.

An average thickness of the adhesive layer is not particularly restricted, and it may be appropriately selected according to purpose. Nonetheless, it is preferably 3 µm to 100 µm, more preferably 5 µm to 30 µm, and particularly preferably 8 µm to 20 µm. When the average thickness is less than 3 µm, there are cases where adhesive strength significantly decreases. When it exceeds 100 µm, the adhesive layer protrudes from the tab line, causing failure in an electrical connection. The average thickness in the particularly preferable range is advantageous in view of adhesion reliability.

Here, the average thickness is an average value of measurements at arbitrarily selected five (5) locations per 20cm².

An average width of the adhesive layer is not particularly restricted, may be appropriately selected according to purpose. Nonetheless, it is preferably 0.5 mm to 10 mm, and it preferably has a width same as or smaller than the width of the tab line.

### -Adhesive-

The adhesive is not particularly restricted, and it may be appropriately selected according to purpose. Examples thereof include an electrically conductive adhesive and an insulating adhesive.

### --Electrically conductive adhesive--

The electrically conductive adhesive is not particularly restricted, and it may be appropriately selected according to purpose. Examples thereof include an adhesive including electrically conductive particles, a film-forming resin, a hardening resin and a curing agent and further including other components such as silane coupling agent according to necessity.

### --Insulating adhesive--

The insulating adhesive is not particularly restricted, and it may be appropriately selected according to purpose. Examples thereof include an adhesive including a film-forming resin, a hardening resin and a curing agent and further including other components such as silane coupling agent according to necessity.

### --Electrically conductive particles--

The electrically conductive particles are not particularly restricted, and they may be appropriately selected according to purpose. Examples thereof include nickel particles, gold-coated nickel particles, resin particles including a resin core coated with Ni and resin particles including a resin core coated with Ni and an outermost surface thereof coated with Au.

### ---Film-forming resin---

The film-forming resin is not particularly restricted, may be appropriately selected according to purpose. Examples thereof include a phenoxy resin, an unsaturated polyester resin, a saturated polyester resin, an urethane resin, a butadiene resin, a polyimide resin, a polyamide resin and a polyolefin resin. These may be used alone or in combination of two or more. Among these, the phenoxy resin is particularly preferable.

### ---Hardening resin---

The hardening resin is not particularly restricted, and it may be appropriately selected according to purpose. Examples thereof include an epoxy resin and an acrylate resin.

### ----Epoxy resin----

The epoxy resin is not particularly restricted, and it may be appropriately selected according to purpose. Examples thereof include a bisphenol A epoxy resin, a bisphenol F epoxy resin, a novolak epoxy resin, modified epoxy resins thereof and an alicyclic epoxy resin. These may be used alone or in combination of two or more.

### ----Acrylate resin----

The acrylate resin is not particularly restricted, and it may be appropriately selected according to purpose. Examples thereof include methyl acrylate, ethyl acrylate, isopropyl acrylate, isobutyl acrylate, epoxy acrylate, ethylene glycol diacrylate, diethylene glycol diacrylate, trimethylolpropane triacrylate, dimethyloltricyclodecane acrylate, tetramethylene glycol tetraacrylate, 2-hydroxy-1,3-diacryloxypropane, 2,2-bis[4-(acryloxymethoxy)phenyl]propane, 2,2-bis[4-(acryloxyethoxy)phenyl]propane, dicyclopentenyl acrylate, tricyclodecanyl acrylate, tris(acryloxyethyl)isocyanurate and urethane acrylate. These may be used alone or in combination of two or more.

The examples further include those with the acrylate replaced by a methacrylate. These may be used alone or in combination of two or more.

### ---Curing agent---

The hardening resin is used preferably in combination with a curing agent. The curing agent is not particularly restricted, and it may be appropriately selected according to purpose. Examples thereof include: imidazoles typified by 2-ethyl-4-methylimidazole; organic peroxides such as lauroyl peroxide, butyl peroxide, benzyl peroxide, dilauroyl peroxide, dibutyl peroxide, benzyl peroxide, peroxydicarbonate and benzoyl peroxide; anionic curing agents such as organic amines; cationic curing agents such as sulfonium salt, onium salt and aluminum chelating agent.

Among these, a combination of the epoxy resin and the imidazole-based latent curing agent and a combination of the acrylate resin and the organic peroxide curing agent are particularly preferable.

### ---Silane coupling agent---

The silane coupling agent is not particularly restricted, and it may be appropriately selected according to purpose. Examples thereof include an epoxy silane coupling agent, an acrylic silane coupling agent, a thiol-based silane coupling agent and an amine-based silane coupling agent.

### ---Other components---

The other components are not particularly restricted, and they may be appropriately selected according to purpose. Examples thereof include a filler, a softener, an accelerator, an anti-aging agent, a colorant (pigments, dyes), an organic solvent, and an ion catcher. An added amount of the other components is not particularly restricted, and it may be appropriately selected according to purpose.

The ratio (Rz/A) of the ten-point average roughness of the convex portions on the tab line (Rz (µm)) to the average thickness of the adhesive layer (A (µm)) is not particularly restricted, and it may be appropriately selected according to purpose. Nonetheless, it is preferably 0.5 to 2.0, and more preferably 0.8 to 1.5. When the ratio (Rz/A) is less than 0.5, the adhesive layer is thick, and there are cases where connection reliability decreases. When it exceeds 2.0, the adhesive layer is thin, and there are cases where adhesion decreases. The ratio (Rz/A) in the more preferable range is advantageous in view of superior connection reliability and adhesive property.

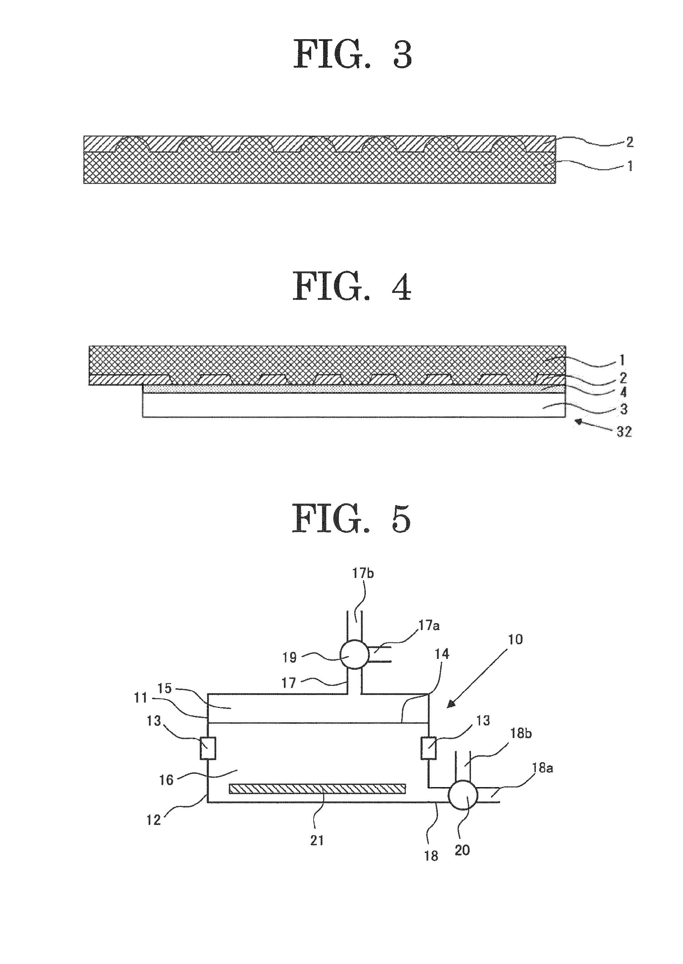

FIG. 3 is a schematic cross-sectional diagram of the tab line including the convex portions on which the adhesive layer is laminated. An adhesive layer 2 is laminated only on one surface of a tab line 1 including convex portions.

### <Sealing resin>

The sealing resin is not particularly restricted, and it may be appropriately selected according to purpose. Examples thereof include an ethylene/vinyl acetate copolymer (EVA), an ethylene/vinyl acetate/triallyl isocyanurate copolymer (EVAT), polyvinyl butyrate (PVB), a polyisobutylene (PIB), silicone resin and a polyurethane resin.

The polyurethane resin is not particularly restricted, and it may be appropriately selected according to purpose. Nonetheless, a blend polymer of a thermoplastic polyurethane resin including an ester-based polyol unit and a thermoplastic polyurethane resin including an ether-based polyol unit is preferable. The thermoplastic polyurethane resin including an ester-based polyol unit has a characteristic of a relatively high adhesive strength, and the thermoplastic polyurethane resin including an ether-based polyol unit has a characteristic that hydrolysis thereof is relatively difficult. These characteristics are reflected strongly on this blend polymer.

### <Moisture-proof back sheet>

The moisture-proof back sheet is not particularly restricted, may be appropriately selected according to purpose. Examples thereof include polyethylene terephthalate (PET), aluminum (Al) and a laminate of PET, Al and polyethylene (PE).

### <Glass plate>

The glass plate is not particularly restricted, and it may be appropriately selected according to purpose. Examples thereof include soda-lime float glass plate.

In the solar cell module, the electrode and the surface of the tab line including the convex portions are adhered and are electrically connected via the adhesive layer.

A method for adhering and electrically connecting the electrode and the one surface of the tab line including the convex portions via the adhesive layer is not particularly restricted, and it may be appropriately selected according to purpose. Examples thereof include a method of disposing the tab line on which the adhesive layer is laminated on the one surface thereof including the convex portions on the electrode of the thin-film solar cell such that the electrode and the adhesive layer are in contact, followed by pressing and heating. As such a method, a method for manufacturing the thin-film solar cell module of the present invention described later is preferable.

FIG. 4 is a schematic cross-sectional diagram illustrating one example of the thin-film solar cell module of the present invention. A thin-film solar cell 32 includes a photoelectric conversion element 3 and an electrode 4, and the electrode 4 and the one surface of the tab line 1 including the convex portions are adhered via the adhesive layer 2. The electrode 4 and the convex portions are in contact, and the electrode 4 and the tab line 1 are electrically connected.

Examples of a schematic top view of the thin-film solar cell module include the schematic top view of FIG. 2.

In the thin-film solar cell module, the convex portions on the tab line improves the electrical connection between the electrode of the thin-film solar cell and the tab line. Thus, the thin-film solar cell module has superior connection reliability. Also, since the thin-film solar cell module includes the adhesive layer only on one surface of the tab line, equipments are not contaminated during manufacturing the thin-film solar cell module.

### (Method for Manufacturing Thin-Film Solar Cell Module)

A method for manufacturing a thin-film solar cell module of the present invention uses a decompression laminator, it includes a disposing step, a pressing step and a heating step, and it further includes other steps according to necessity.

The thin-film solar cell module of the present invention may be manufactured by the method for manufacturing a thin-film solar cell module of the present invention.

### <Decompression laminator>

The decompression laminator includes a first chamber, a second chamber, a flexible sheet and a heating stage, and it further includes other members according to necessity.

The first chamber and the second chamber are partitioned by the flexible sheet.

An internal pressured of each of the first chamber and the second chamber may be adjusted independently.

The heating stage may be heated, and it is disposed in the second chamber.

Here, an operation of the decompression laminator is explained with reference to figures. FIG. 5 is a schematic cross-sectional diagram of one example of the decompression laminator before use. A decompression laminator 10 is composed of an upper unit 11 and a lower unit 12. These units are separably integrated via a seal member 13 such as O-ring. On the upper unit 11, a flexible sheet 14 such as silicone rubber is disposed, and by this flexible sheet 14, the decompression laminator 10 is partitioned into a first chamber 15 and a second chamber 16. On a surface of the flexible sheet 14 toward the second chamber 16, a thin glass cloth-reinforced TEFLON (registered trademark) sheet may be disposed to avoid transference of a melted sealing resin such as EVA.

Also, pipes 17, 18 are respectively installed on the upper unit 11 and the lower unit 12 so that an internal pressure of the respective chambers are independently adjusted; that is, decompressing, pressurizing and venting are possible with a vacuum pump or a compressor. The pipe 17 is branched in two directions, a pipe 17a and a pipe 17b, at a diversion valve 19, and the pipe 18 is branched in two directions, a pipe 18a and a pipe 18b, at a diversion valve 20. Also, a heating stage 21 which may be heated is disposed in the lower unit 12.

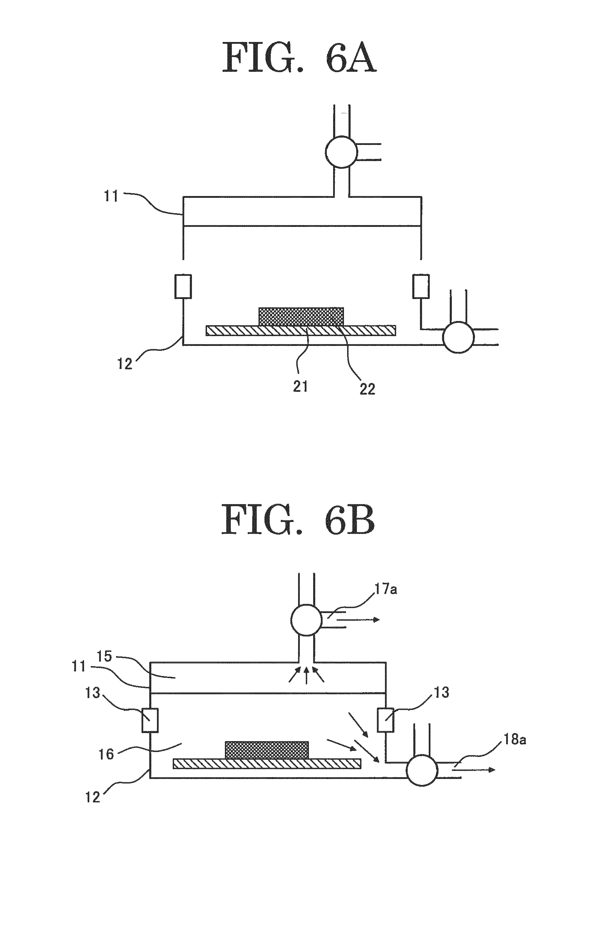

The decompression laminator 10 as described above is used, for example, as illustrated in FIG. 6A to FIG. 6E.

First, as illustrated in FIG. 6A, the upper unit 11 and the lower unit 12 are separated, and on the heating stage 21, a laminate 22 which should be thermally laminated is disposed.

Next, as illustrated in FIG. 6B, the upper unit 11 and the lower unit 12 are separably integrated via the seal member 13. Thereafter, a vacuum pump (not shown) is connected to each of the pipe 17a and the pipe 18a, and the first chamber 15 and the second chamber 16 are vacuated.

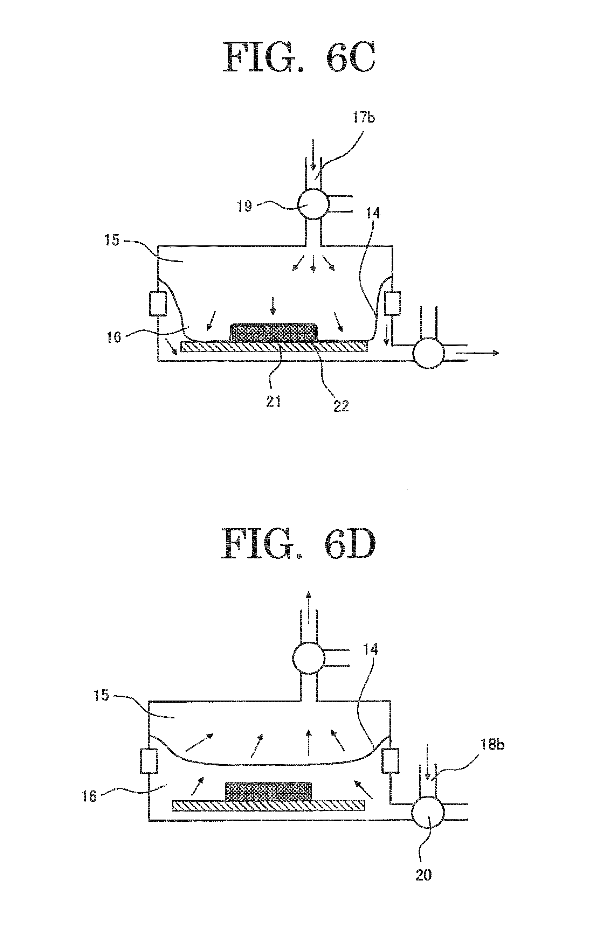

Next, as illustrated in FIG. 6C, while the high vacuum is maintained in the second chamber 16, the diversion valve 19 is switched, and air is introduced from the pipe 17b into the first chamber 15. Thereby, the flexible sheet 14 is pushed toward the second chamber 16. On this occasion, the heating stage 21 is heated. As a result, the laminate 22 is pressed by the flexible sheet 14 while being heated by the heating stage 21.

Next, as illustrated in FIG. 6D, the diversion valve 20 is switched, and air is introduced from the pipe 18b into the second chamber 16. Thereby, the flexible sheet 14 is pressed back toward the first chamber 15, and in the end, the first chamber 15 and the second chamber 16 have the same internal pressure.

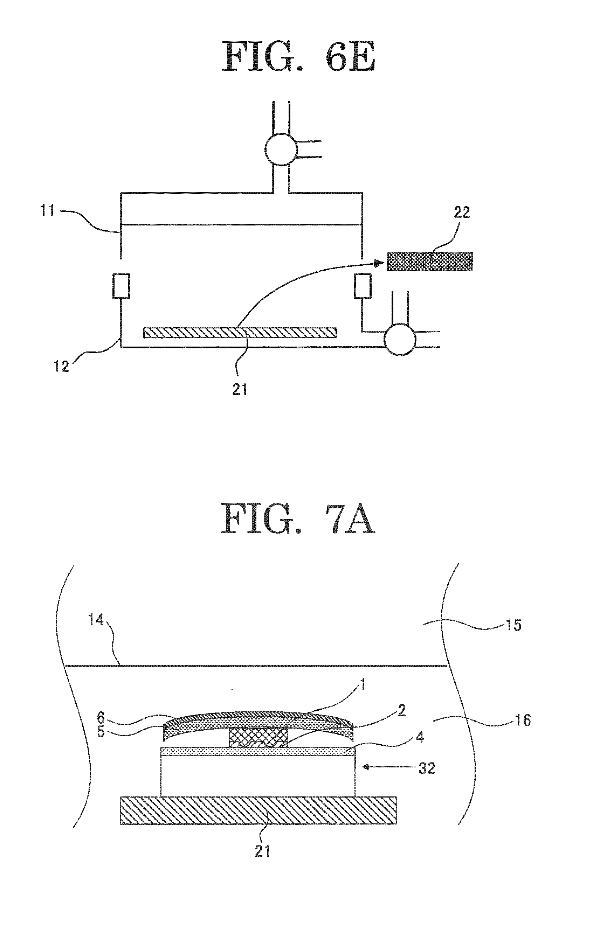

At last, as illustrated in FIG. 6E, the upper unit 11 and the lower unit 12 are separated, and the laminate 22 processed for thermal lamination is taken out from the heating stage 21. Thereby, an operating cycle of the decompression laminator 10 is completed.

Here, in the method for manufacturing a thin-film solar cell module, the laminate 22 becomes the thin-film solar cell module of the present invention.

By carrying out the operations illustrated in FIG. 6A to FIG. 6E, a step of connecting a tab line and an electrode and a step of sealing with a sealing resin may be collectively carried out.

Having described an example of the decompression laminator, the decompression laminator is not restricted to the laminator composed of the upper unit and the lower unit illustrated in FIG. 5. It is also possible to use a decompression laminator having a chassis divided into two chambers and configured to dispose and recover a laminate by opening and closing a door. Also, regarding the first chamber and the second chamber, compressed air may be introduced into the first chamber for pressurization above atmospheric pressure, or air inside the chamber may be simply evacuated without having to reduce the pressure in the second chamber.

Next, the method for manufacturing a thin-film solar cell module of the present invention using the decompression laminator explained above is explained.

### <Disposing step>

The disposing step is not particularly restricted as long as it is a step of disposing the thin-film solar cell module of the present invention prior to the step of connecting a tab line and an electrode and the step of sealing with a sealing resin on the heating stage in the second chamber, and it may be appropriately selected according to purpose. For example, a thin-film solar cell with an electrode formed thereon is disposed on the heating stage in the second chamber; a tab line with an adhesive layer and convex portions disposed only on one surface thereof are disposed on the electrode so that the electrode and the one surface of the tab line are adhered and electrically connected via the adhesive layer by means of pressing and heating; and further the sealing resin and either the moisture-proof back sheet or the glass plate are disposed so as to cover the thin-film solar cell.

One example of the disposing step is the following step.

First, on the heating stage, a thin-film solar cell on which an electrode has been formed is disposed. Next, on the electrode, a tab line on which an adhesive layer and convex portions disposed only on one surface thereof is disposed so that the electrode and the one surface of the tab line are adhered and electrically connected via the adhesive layer by means of pressing and heating. Next, a sealing resin and either a moisture-proof back sheet or a glass plate is disposed so as to cover the thin-film solar cell.

Another example of the disposing step is the following step.

First, on an electrode of a thin-film solar cell, a tab line with an adhesive layer and convex portions disposed only on one surface thereof is disposed so that the electrode and the one surface of the tab line are adhered and electrically connected via the adhesive layer by means of pressing and heating. Next, the thin-film solar cell on which the adhesive layer and the tab line are disposed is disposed on the heating stage. Next, a sealing resin and either a moisture-proof back sheet or a glass plate is disposed so as to cover the thin-film solar cell.

Here, as the thin-film solar cell, the adhesive layer, the tab line, the sealing resin, the moisture-proof back sheet and the glass plate, those described in the explanation of the thin-film solar cell module of the present invention may be used.

It is preferable that the tab line and the adhesive layer are laminated before disposing them on the electrode in view of simplifying the step and reducing misalignment of the placement.

### <Pressing step>

The pressing step is not particularly restricted as long as it is a step of increasing the internal pressure of the first chamber relative to the second chamber to press either the moisture-proof back sheet or the glass plate by the flexible sheet, and it may be appropriately selected according to purpose.

The operation of increasing the internal pressure of the first chamber relative to the second chamber is not particularly restricted, and it may be appropriately selected according to purpose. Nonetheless, an operation of reducing internal pressures of the first chamber and the second chamber and then venting the first chamber while maintaining the reduced-pressure condition of the second chamber is preferable since the pressing step becomes simple due to the simple operation of venting the first chamber and the reduced internal pressure of the second chamber makes it difficult for voids (air bubbles) to get mixed in the thin-film solar cell module to be produced.

A pressure at which either the moisture-proof back sheet or the glass plate is pressed is not particularly restricted, and it may be appropriately selected according to purpose.

A duration for which either the moisture-proof back sheet or the glass plate is pressed is not particularly restricted, and it may be appropriately selected according to purpose.

### <Heating step>

The heating step is not particularly restricted as long as it is a step of heating the heating stage, and it may be appropriately selected according to purpose.

By heating the heating stage, the adhesive layer and the sealing resin may be heated via the thin-film solar cell disposed on the heating stage.

A heating temperature in the heating step is not particularly restricted, and it may be appropriately selected according to purpose. Nonetheless, it is preferably 50°C to 250°C, more preferably 100°C to 200°C, and particularly preferably 120°C to 170°C. When the heating temperature is less than 50°C, there are cases where adhesion and sealing between the electrode and the tab line are insufficient. When it exceeds 250°C, there are cases where organic resins in the adhesive layer and the sealing resin thermally decompose. The heating temperature in the particularly preferable range is advantageous in view of reliability in both adhesion and connection. Further, it is also advantageous in view of collective connection of a sealing resin in a laminate sealing step.

A heating time in the heating step is not particularly restricted, and it may be appropriately selected according to purpose. Nonetheless, it is preferably 1 minute to 1 hour, more preferably 3 minutes to 30 minutes, and particularly preferably 5 minutes to 20 minutes. When the heating time is less than 1 minute, there are cases where adhesion and sealing between the electrode and the tab line are insufficient. When it exceeds 1 hour, there are cases where adhesive strength decreases. The heating time in the particularly preferable range is advantageous in view of reliability in both adhesion and connection.

An order of starting the pressing step and the heating step is not particularly restricted, and it may be appropriately selected according to purpose. The heating stage may be heated before starting the pressing step, or the heating stage is heated after starting the pressing step.

Next, the disposing step, the pressing step and the heating step are explained in detail with reference to figures.

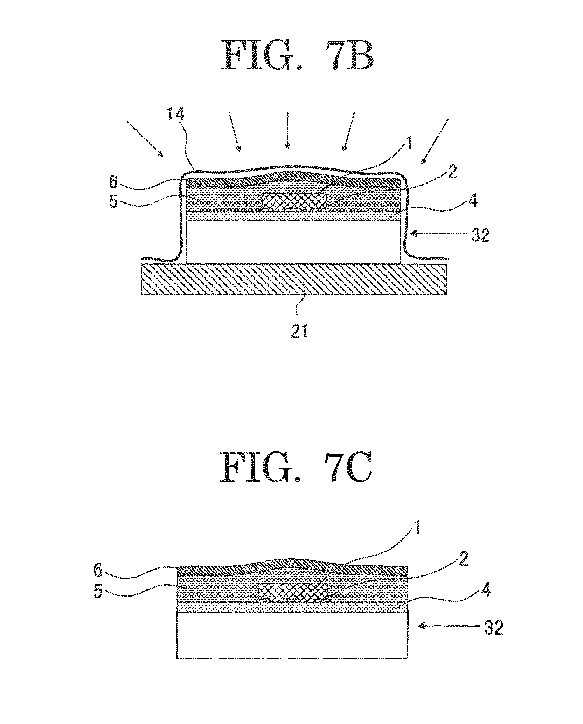

FIG. 7A is a schematic cross-sectional diagram (a partially enlarged diagram of the decompression laminator) for explaining the disposing step. FIG. 7B is a schematic cross-sectional diagram for explaining the pressing step and the heating step. FIG. 7C is a schematic cross-sectional diagram illustrating one example of the thin-film solar cell module of the present invention.

As illustrated in FIG. 7A, a thin-film solar cell 32 with an electrode 4 formed thereon is disposed on the heating stage 21 of the second chamber 16 partitioned from the first chamber 15 by the flexible sheet 14. Next, a tab line 1 with an adhesive layer 2 and convex portions disposed only on one surface thereof is disposed on the electrode 4 so that the electrode 4 and the one surface of the tab line 1 are adhered and electrically connected via the adhesive layer 2 by means of pressing and heating. Next, a sealing resin 5 and a moisture-proof back sheet 6 are sequentially disposed so as to cover the thin-film solar cell 32.

Next, as illustrated in FIG. 7B, having reduced the internal pressures of the first chamber and the second chamber, the first chamber is vented while maintaining the reduced pressure of the second chamber. Thereby, with the flexible sheet 14 pressing the moisture-proof back sheet 6, the thin-film solar cell 32 is heated by heating the heating stage 21. Thereby, the electrode 4 and the tab line 1 of the thin-film solar cell 32 are adhered and electrically connected by the adhesive layer 2, and further the thin-film solar cell 32 is sealed by the sealing resin. Thereby, the thin-film solar cell module may be obtained (FIG. 7C).

### Examples

Hereinafter, examples of the present invention are explained, but these examples shall not be construed as limiting the present invention.

### (Example 1)

### <Preparation of tab line with adhesive layer>

### -Preparation of copper foil with convex portions-

Copper particles were disposed on one surface of a copper foil, and then the copper foil was plated with zinc. Thereby, a copper foil including convex portions only on one surface thereof (copper foil with convex portions) was prepared.

A ten-point average roughness (Rz) of the convex portions of the obtained copper foil was measured in accordance with JIS B 0601-2001 (compliant with ISO 4287-1997), and it was 9 µm.

### -Preparation of insulating adhesive film-

An insulating adhesive composition was prepared by mixing: 30 parts by mass of a phenoxy resin (YP-50, manufactured by Tohto Kasei Co., Ltd.); 24 parts by mass of an epoxy resin (EPICOAT 630, manufactured by Yuka Shell Epoxy KK); 25 parts by mass of a liquid epoxy-dispersed imidazole-based curing resin (NOVACURE 3941HP, manufactured by Asahi Kasei Corporation); and 1 parts by mass of a silane coupling agent (A-187, manufactured by Momentive Performance Materials Inc.).

Next, the obtained insulating adhesive composition was coated on a polyethylene terephthalate film having a surface subjected to a peeling treatment and having a thickness of 50 µm. It was heated in an over at 80°C for 5 minutes for film formation, and thereby an insulating adhesive film having a thickness of 5 µm was obtained.

### -Laminate and slit-

The insulating adhesive film is laminated on a surface including the convex portions of the obtained copper foil, and thereby a copper foil with the insulating adhesive film laminated thereon was prepared. Next, the copper foil with the insulating adhesive film laminated thereon was slit to a width of 4 mm, and thereby a tab line with an adhesive layer was prepared.

### <Preparation of thin-film solar cell module model>

A silver of a firing type was coated and fired on a surface of a glass substrate (40 mm × 15 mm × thickness of 0.7 mm, alkali-free glass), and a glass substrate with a silver electrode as an electrode thereof was prepared.

The obtained tab line with the adhesive layer was arranged on the electrode on the glass substrate with the electrode such that the electrode was in contact with the adhesive layer, which was subjected to thermal lamination for 20 minutes at a pressure of 100 kPa and a heating temperature of 160°C using a thermal laminator from a side of the tab line. Thereby, a thin-film solar cell module model was prepared.

### <Evaluation>

### -Tackiness-

A tack was measured under the following test conditions using a tacking test equipment manufactured by Rhesca Corporation. Measurements were taken at three (3) locations per sample, and an average value thereof was obtained and evaluated based on the following evaluation criteria. Results are shown in Table 1-1.

### [Test conditions]

| | |
|---|---|
| Probe diameter: | 5 mm in diameter |
| Immersion speed: | 30 mm/min |
| Test speed: | 120 mm/min |
| Preload: | 196.25 gf |
| Press time: | 1.0 sec |
| Distance: | 2.0 mm |

### [Evaluation criteria]

A: 0.5 N or greater
B: 0N or greater and less than 0.5 N

### -Connection reliability-

A resistance value was measured by a four-terminal method, where current terminals and voltage terminals were respectively connected from two (2) tab lines, and it was evaluated based on the following evaluation criteria. Results are shown in Table 1-1.

### [Evaluation criteria]

AA: less than 10Ω
A: 10Ω or greater and less than 20Ω
B: 20Ω or greater and less than 300Ω
F: 300Ω or greater (including over range)

### -Contamination of mounting equipment-

The tab line with the adhesive layer and the glass substrate with the electrode are adhered by a taping equipment, and contamination on a surface of a paste roller was measured and evaluated based on the following evaluation criteria. Results are shown in Table 1-1.

### [Evaluation criteria]

A: No contamination of the roller occurred with one or more times of adhesion.

F: Contamination occurred of the roller occurred with one time of adhesion.

### (Example 2)

A thin-film solar cell module model was prepared in the same manner as Example 1 except that the thickness of the insulating adhesive film was changed from 5 µm in Example 1 to 8 µm

The obtained thin-film solar cell module model was evaluated in the same manner as Example 1. Results are shown in Table 1-1.

### (Example 3)

A thin-film solar cell module model was prepared in the same manner as Example 1 except that the thickness of the insulating adhesive film was changed from 5 µm in Example 1 to 11 µm

The obtained thin-film solar cell module model was evaluated in the same manner as Example 1. Results are shown in Table 1-1.

### (Example 4)

A thin-film solar cell module model was prepared in the same manner as Example 1 except that the thickness of the insulating adhesive film was changed from 5 µm in Example 1 to 18 µm

The obtained thin-film solar cell module model was evaluated in the same manner as Example 1. Results are shown in Table 1-1.

### (Example 5)

A thin-film solar cell module model was prepared in the same manner as Example 1 except that the thickness of the insulating adhesive film was changed from 5 µm in Example 1 to 20 µm

The obtained thin-film solar cell module model was evaluated in the same manner as Example 1. Results are shown in Table 1-1.

### (Example 6)

A thin-film solar cell module model was prepared in the same manner as Example 1 except that the insulating adhesive film in Example 1 was replaced by an electrically conductive adhesive film prepared as follows.

The obtained thin-film solar cell module model was evaluated in the same manner as Example 1. Results are shown in Table 1-1.

### <Preparation of electrically conductive adhesive film>

An electrically conductive adhesive composition was prepared by mixing: 30 parts by mass of a phenoxy resin (YP-50, manufactured by Tohto Kasei Co., Ltd.); 24 parts by mass of an epoxy resin (EPICOAT 630, manufactured by Yuka Shell Epoxy KK); 25 parts by mass of a liquid epoxy-dispersed imidazole-based curing resin (NOVACURE 3941HP, manufactured by Asahi Kasei Corporation); 1 parts by mass of a silane coupling agent (A-187, manufactured by Momentive Performance Materials Inc.); and 50 parts by mass of electrically conductive particles (F255, manufactured by Vale Japan Limited).

Next, the obtained electrically conductive adhesive composition was coated on a polyethylene terephthalate film having a surface subjected to a peeling treatment and having a thickness of 50 µm. It was heated in an oven at 80°C for 5 minutes for film formation, and thereby an electrically conductive adhesive film having a thickness of 11 µm was obtained.

### (Example 7)

A thin-film solar cell module model was prepared in the same manner as Example 1 except that the copper foil with convex portions in Example 1 was replaced by a copper foil with convex portions prepared as follows.

The obtained thin-film solar cell module model was evaluated in the same manner as Example 1. Results are shown in Table 1-1.

### <Preparation of copper foil with convex portions>

Copper particles were disposed on one surface of a copper foil, and then the copper foil was plated with zinc. Thereby, a copper foil including convex portions only on one surface thereof (copper foil with convex portions) was prepared.

A ten-point average roughness (Rz) of the convex portions of the obtained copper foil was measured in accordance with JIS B 0601-2001 (compliant with ISO 4287-1997), and it was 3.3 µm.

### (Example 8)

A thin-film solar cell module model was prepared in the same manner as Example 1 except that the insulating adhesive film in Example 1 was replaced by an insulating adhesive film prepared as follows.

### <Preparation of insulating adhesive film>

An insulating adhesive composition was prepared by mixing: 35 parts by mass of a phenoxy resin (PKHH, manufactured by InChem Corporation); 14 parts by mass of an epoxy resin (YL980, manufactured by Japan Epoxy Resin Co., Ltd.); 30 parts by mass of a liquid epoxy-dispersed imidazole-based curing resin (NOVACURE 3941HP, manufactured by Asahi Kasei Corporation); and 1 parts by mass of a silane coupling agent (A-187, manufactured by Momentive Performance Materials Inc.).

Next, the obtained insulating adhesive composition was coated on a polyethylene terephthalate film having a surface subjected to a peeling treatment and having a thickness of 50 µm. It was heated in an over at 80°C for 5 minutes for film formation, and thereby an insulating adhesive film having a thickness of 11 µm was obtained.

### (Comparative Example 1)

A thin-film solar cell module model was prepared in the same manner as Example 2 except that the copper foil with convex portions in Example 2 was replaced by a tin-plated copper foil prepared as follows.

The obtained thin-film solar cell module model was evaluated in the same manner as Example 1. Results are shown in Table 1-2.

### <Preparation of tin-plated copper foil>

A copper foil was plated with tin (the plated tin had a thickness of 1 µm on each surface), and thereby tin-plated copper foil was prepared.

### (Comparative Example 2)

A thin-film solar cell module model was prepared in the same manner as Comparative Example 1 except that the thickness of the insulating adhesive film was changed from 8 µm in Comparative Example 1 to 11 µm.

The obtained thin-film solar cell module model was evaluated in the same manner as Example 1. Results are shown in Table 1-2.

### (Comparative Example 3)

A thin-film solar cell module model was prepared in the same manner as Comparative Example 1 except that the thickness of the insulating adhesive film was changed from 8 µm in Comparative Example 1 to 18 µm.

The obtained thin-film solar cell module model was evaluated in the same manner as Example 1. Results are shown in Table 1-2.

### (Comparative Example 4)

A thin-film solar cell module model was prepared in the same manner as Comparative Example 1 except that the thickness of the insulating adhesive film was changed from 8 µm in Comparative Example 1 to 20 µm.

The obtained thin-film solar cell module model was evaluated in the same manner as Example 1. Results are shown in Table 1-2.

### (Comparative Example 5)

A thin-film solar cell module model was prepared in the same manner as Example 1 except that the tab line with the adhesive layer in Example 1 was replaced by a tab line with an adhesive layer prepared as follows. Here, thermal lamination was carried out with the electrode and the convex portions in contact.

The obtained thin-film solar cell module model was evaluated in the same manner as Example 1. Results are shown in Table 1-2.

### <Preparation of tab line with adhesive layer>

Using a laminator, an insulating adhesive film identical to the insulating adhesive film obtained Example 1 except that the thickness thereof was changed to 11 µm was laminated on the surface of the copper foil with convex portions including the convex portions obtained in Example 1, and thereby a copper foil with the insulating adhesive film laminated thereon was prepared. Next, the insulating adhesive film (thickness: 11 µm) was also laminated on a surface including no convex portions of the copper foil (a surface opposite to the surface including convex portions), and thereby a copper foil with the insulating adhesive film laminated on both surfaces thereof was prepared. Further, this copper foil was slit to a width of 4 mm, and a tab line with an adhesive layer was prepared.

### (Comparative Example 6)

A thin-film solar cell module model was prepared in the same manner as Example 1 except that the tab line with the adhesive layer in Example 1 was replaced by a tab line with an adhesive layer prepared as follows. Here, thermal lamination was carried out with the electrode and the convex portions in contact.

The obtained thin-film solar cell module model was evaluated in the same manner as Example 1. Results are shown in Table 1-2.

### <Preparation of tab line with adhesive layer>

Using a laminator, an electrically conductive adhesive film (thickness: 11 µm) obtained in Example 6 was laminated on the surface including convex portions of the copper foil with convex portions obtained in Example 1, and thereby a copper foil with the electrically conductive adhesive film laminated thereon was prepared. Next, the electrically conductive adhesive film (thickness: 11 µm) was also laminated on a surface including no convex portions of the copper foil (a surface opposite to the surface including convex portions), and thereby a copper foil with the electrically conductive adhesive film laminated on both surfaces thereof was prepared. Further, this copper foil was slit to a width of 4 mm, and a tab line with an adhesive layer was prepared.

**Table 1-1**

| | | Example | | | | | | | |
|---|---|---|---|---|---|---|---|---|---|
| | | 1 | 2 | 3 | 4 | 5 | 6 | 7 | 8 |
| shape of tab line (presence or absence of convex portions) | | Presence | Presence | Presence | Presence | Presence | Presence | Presence | Presence |
| Rz(µm) of convex portions | | 9 | 9 | 9 | 9 | 9 | 9 | 3.3 | 9 |
| Location of adhesive layer relative to tab line | | One surface | One surface | One surface | One surface | One surface | One surface | One surface | One surface |
| thickness [A] (µm) of adhesive layer | | 5 | 8 | 11 | 18 | 20 | 11 | 5 | 11 |
| Rz/A | | 1.80 | 1.13 | 0.82 | 0.50 | 0.45 | 0.82 | 0.66 | 0.82 |
| Presence or absence of electrically conductive particles in adhesive layer | | Absence | Absence | Absence | Absence | Absence | Presence | Absence | Absence |
| Tackiness | | B | A | A | A | A | B | B | A |
| Connecti on reliability | Initial | AA | AA | AA | A | B | AA | A | AA |
| | After 500 hr at 85°C 85%R H | A | AA | AA | B | B | AA | B | AA |
| Contamination of mounting equipment | | A | A | A | A | A | A | A | A |

**Table 1-2**

| | | Comparative Example | | | | | |
|---|---|---|---|---|---|---|---|
| | | 1 | 2 | 3 | 4 | 5 | 6 |
| shape of tab line (presence or absence of convex portions) | | Absence | Absence | Absence | Absence | Presence | Presence |
| Rz (µm) of convex portions | | - | - | - | - | 9 | 9 |
| Location of adhesive layer relative to tab line | | One surface | One surface | One surface | One surface | Both surfaces | Both surfaces |
| thickness [A] (µm) of adhesive layer | | 8 | 11 | 18 | 20 | 11 | 11 |
| Rz/A | | - | - | - | - | 0.82 | 0.82 |
| Presence or absence of electrically conductive particles in adhesive layer | | Absence | Absence | Absence | Absence | Absence | Presence |
| Tackiness | | A | A | A | A | A | B |
| Connecti on reliability | Initial | B | F | F | F | A | AA |
| | After 500 hr at 85°C 85%R H | F | F | F | F | B | A |
| Contamination of mounting equipment | | A | A | A | A | F | F |

### (Example 9)

Using a thin-film solar cell model, a method for manufacturing a thin-film solar cell module of the present invention was carried out. The method is described as follows.

A decompression laminator illustrated in FIG. 5 was used.

As illustrated in FIG. 7A, the glass substrate with the electrode prepared in Example 1 (corresponding to a thin-film solar cell 32 with an electrode 4 formed thereon in FIG. 7A) was arranged on a heating stage 21 of a second chamber 16 partitioned from a first chamber 15 by a flexible sheet 14. Next, the tab line with the adhesive layer prepared in Example 1 (corresponding to a tab line 1 with an adhesive layer 2 and convex portions only on one surface thereof in FIG. 7A) was arranged on the electrode such that the electrode and the one surface of the tab line including the convex portions are adhered and electrically connected via the adhesive layer by pressing and heating. Next, a sealing resin 5 (ethylene/vinyl acetate copolymer having a thickness of 500 µm) and a moisture-proof back sheet 6 (a polyethylene terephthalate (BS-SP, manufactured by Toppan Printing Co., Ltd.) having a thickness of 250 µm) were sequentially disposed so as to cover the glass substrate with the electrode.

Next, internal pressures of the first chamber and the second chamber were reduced. Then, as illustrated in FIG. 7B, while maintaining the reduced-pressure condition of the second chamber, the first chamber was vented. With the moisture-proof back sheet 6 pressed by the flexible sheet 14, the heating stage 21 was heated so as to heat the glass substrate with the electrode. At this time, the pressure was 100 kPa, the heating temperature was 160°C, and the time for pressing and heating was 20 minutes. Thereby, the electrode of the glass substrate with the electrode and the tab line were adhered and electrically connected by the adhesive layer, and further, the glass substrate with the electrode was sealed with the sealing resin. Thereby, the thin-film solar cell module model was obtained (FIG. 7C).

By the manufacturing method using the decompression laminator, it was possible to carry out collectively the adhesion and the electrical connection of the electrode and the tab line as well as the sealing by the sealing resin.

Also, since the moisture-proof back sheet of the obtained thin-film solar cell module model was pressed in a reduced-pressure atmosphere, there was no air bubbles trapped in the module sealed by the sealing resin.

### Industrial Applicability

A thin-film solar cell module of the present invention has superior connection reliability in a thin-film solar cell module which employs an adhesive as a connecting material, and thus it may be favorably used as a clean energy source. Also, a method for manufacturing a thin-film solar cell module of the present invention enables production with fewer steps, and thus it may be favorably used for manufacturing the thin-film solar cell module of the present invention.

### Reference Signs List

- 1: Tab line
- 2: Adhesive layer
- 3: Photoelectric conversion element
- 4: Electrode
- 5: Sealing resin
- 6: Moisture-proof back sheet
- 10: Decompression laminator
- 11: Upper unit
- 12: Lower unit
- 13: Seal member
- 14: Flexible sheet
- 15: First chamber
- 16: Second chamber
- 17, 17a, 17b: Pipe
- 18, 18a, 18b: Pipe
- 19: Diversion valve
- 20: Diversion valve
- 21: Heating stage
- 22: Laminate
- 32, 32c, 32d: Thin-film solar cell
- 38: Substrate
- 40: Conductive adhesive layer
- 41: First electrode
- 42: Finger electrode
- 43: Second electrode
- 44: Finger electrode
- 50: Crystalline solar cell
- 100: Crystalline solar cell module
- 200: Thin-film solar cell module

## Claims

1. A thin-film solar cell module, comprising:
a thin-film solar cell comprising an electrode;
a tab line; and
an adhesive layer,
wherein the tab line comprises convex portions only on one surface thereof,
wherein the adhesive layer is disposed only on the one surface of the tab line comprising the convex portions, and
wherein the electrode and the one surface of the tab line comprising the convex portions are adhered and are electrically connected via the adhesive layer.

2. The thin-film solar cell module according to claim 1,
wherein a ratio (Rz/A) of a ten-point average roughness of the convex portions comprised in the tab line (Rz (µm)) to an average thickness of the adhesive layer (A (µm)) is 0.5 to 2.0.

3. A method for manufacturing a thin-film solar cell module,
wherein the thin-film solar cell module is the thin-film solar cell module according to claim 1 or 2,
wherein the method uses a decompression laminator,
wherein the decompression laminator comprises a first chamber, a second chamber, a flexible sheet, and a heating stage which is heatable,
wherein the first chamber and the second chamber are partitioned by the flexible sheet,
wherein an internal pressure of each of the first chamber and the second chamber is independently adjustable, and
wherein the heating stage is disposed in the second chamber,
wherein the method comprises:
disposing, wherein the thin-film solar cell with the electrode formed thereon is disposed on the heating stage in the second chamber, the adhesive layer and the tab line with the convex portions only on one surface thereof are disposed on the electrode so that the electrode and the one surface of the tab line are adhered and electrically connected via the adhesive layer by pressing and heating, and further a sealing resin and either a moisture-proof back sheet or a glass plate are disposed so as to cover the thin-film solar cell;
pressing, wherein the internal pressure of the first chamber is increased relative to the second chamber so as to press either the moisture-proof back sheet or the glass plate by the flexible sheet; and
heating, wherein the heating stage is heated.

4. The method for manufacturing a thin-film solar cell module according to claim 3,
wherein the increasing the internal pressure of the first chamber relative to the second chamber is to reduce the internal pressures of the first chamber and the second chamber to a reduced-pressure condition and then to vent the first chamber while maintaining the reduced-pressure condition of the second chamber.

5. The method for manufacturing a thin-film solar cell module according to claim 3 or 4,
wherein the tab line and the adhesive layer are laminated before disposed on the electrode.
